# EUROPEAN PATENT APPLICATION

(11) **EP 1 652 961 A1**
(43) Date of publication of application: **03.05.2006**
(21) Application number: 04747572.8
(22) Date of filing: 15.07.2004
(51) Int. Cl.: C23C 16/02, C23C 16/509, B65D 23/02

(54) **METHOD OF MANUFACTURING GAS BARRIER FILM COATED PLASTIC CONTAINER**

(30) Priority: 17.07.2003 JP 2003198576
(71) Applicant: MITSUBISHI SHOJI PLASTICS CORPORATION, Shinagawa-ku, Tokyo 141-8535 (JP); Youtec Co. Ltd., Nagareyama-shi, Chiba 270-0156 (JP); Kirin Brewery Company, Ltd., Tokyo 104-8288 (JP)
(72) Inventor: TAKEMOTO, Keishu, Shinagawa-ku, Tokyo 1418535 (JP); KAGE, Tsuyoshi, Shinagawa-ku, Tokyo 1418535 (JP); KOBAYASHI, Takumi, Singapore (SG); SHIRAKURA, Akira, Chuo-ku, Tokyo 1048288 (JP)
(74) Representative: Bunke, Holger
(86) International application number: PCT/JP2004/010106
(87) International publication number: WO 2005/007925

(57) **Abstract**

A method of manufacturing a gas barrier film coated plastic container with high gas-barrier properties by solving a problem in a conventional method wherein the formation of a gas barrier film is obstructed by water molecules adsorbed in the plastic container and the container with reduced gas-barrier properties is manufactured. The method is **characterized by** comprising the steps of decreasing a pressure inside the plastic container or decreasing a pressure to the entire part of the plastic container, flowing dry gas as leak gas when vacuum is released to fill the inside of the container with the dry gas for drying the plastic container, replacing the gas inside the plastic container with a material gas or a material gas-containing gas, and plasmatizing the material gas to form the gas barrier film on the inner surface of the plastic container by a CVD method.

## Description

### TECHNOLOGICAL FIELD

The present invention is related to a manufacturing method which forms a gas barrier film on the inner surface of a plastic container.

### PRIOR ART TECHNOLOGY

A gas barrier film coated plastic container is disclosed in Patent Document 1, for example. In this case, a carbon film, namely, a DLC (Diamond-Like Carbon) film is formed as a gas barrier film on the inner surface of a plastic container.

### Patent Document 1

Japanese Laid-Open Patent Application No. HEI 8-53116.

### SUMMARY OF THE INVENTION

### PROBLEMS TO BE SOLVED BY THE INVENTION

The present inventors repeatedly carried out diligent research on gas barrier film coated plastic containers, and discovered that the gas barrier properties of plastic containers are different depending on the storage state of the plastic containers before film formation. Namely, it was discovered that the gas barrier property of a plastic container is lowered when film formation is carried out in the state where the plastic container has absorbed moisture.

The plastic container is formed by molding a parison (preform) from plastic pellets, and then streching by blow molding. The moisture content of the resin immediately after the formation of the plastic container is at least 50ppm in the case of PET (polyethylene terephthalate). On the other hand, in the case where a container is stored in a warehouse or the like after the container is formed but before film formation, the container will absorb moisture. PET bottles have a high hygroscopicity, wherein the equilibrium water absorption coefficient is 0.4 ~ 0.5% by weight at 20°C at a relative humidity of 60 ~ 80%. Further, it is also understood that PET bottles absorb moisture quickly. Recently, instead of integrated manufacturing with parison molding and blow molding, a parison is purchased from company A, and blow molding is carried out by company B. Accordingly, because the period of time from parison molding to blow molding is 3 ~ 30 days, the parison will absorb water in the air until a saturated state is reached.

The present inventors believe that if absorbed water molecules are present inside the resin, when a gas barrier film is formed under reduced pressure by a CVD (Chemical Vapor Deposition) method, the absorbed water molecules will be released from the inside of the plastic which is a substrate, and the source gas ions supplied to the substrate will collide with these water molecules and hinder film formation, thereby lowering the gas barrier property.

It is an object of the present invention to solve the problem of containers being formed with a lowered gas barrier property because the formation of the gas barrier film is hindered by water molecules absorbed in the plastic container, and provide a method of manufacturing a gas barrier film coated plastic container having a high gas barrier property.

Incidentally, plastic containers require mass production. In the case where mass production is carried out, the time required for the film forming process is preferably 12 seconds or less. Even in the case where a film forming process for following mass production in this way can not be carried out over a long time, it is an object to provide a method of manufacturing a gas barrier film coated plastic container which can eliminate the adverse effects of absorbed water molecules described above.

Further, in the present manufacturing method in the present invention, the improvement of the container drying efficiency is made a subject, and the simultaneous use of heating by a resistance wire type electric heater or microwaves is proposed. Further, a drying gas used for eliminating the adverse effects of water molecules is shown in a concrete example. Further, the reduced pressure reached when filling the inside of the container with the dry gas is shown in a concrete example.

Further, the adverse effects of water molecules appear easily when a gas barrier film is formed in a container formed by a resin that absorbs moisture easily. The present invention is not limited to only containers made of resin that absorb moisture easily in this way, but a concrete example of a container made of resin that absorbs moisture easily is shown as a preferred container to be combined with the present manufacturing method.

### MEANS FOR SOLVING THE PROBLEMS

A method of manufacturing a gas barrier film coated plastic container according to the present invention includes the steps of reducing the pressure inside a plastic container or reducing the pressure of the entire plastic container; flowing a dry gas as a leak gas at the time the vacuum is opened to fill the inside of the container with said dry gas to dry said plastic container; and replacing the gas inside said plastic container with a source gas or a gas which includes a source gas, converting said source gas to plasma, and forming a gas barrier film on the inner surface of said plastic container by a CVD method. Vacuum drying is carried out before the container is coated, whereby the adverse effects due to water are eliminated.

In this regard, the reduced pressure inside said plastic container or the reduced pressure of the entire plastic container preferably reaches an attainment pressure of 100 Pa or lower.

Further, a method of manufacturing a gas barrier film coated plastic container according to the present invention includes the steps of blowing the inside of a plastic container with a heated dry gas at 50 ~ 60°C to fill the inside of the container with said heated dry gas to dry said plastic container; and replacing the gas inside said plastic container with a source gas or a gas which includes a source gas, converting said source gas to plasma, and forming a gas barrier film on the inner surface of said plastic container by a CVD method. Drying by heated dry gas is carried out before the container is coated, whereby the adverse effects due to water are eliminated.

In the methods of manufacturing a gas barrier film coated plastic container according to the present invention, said plastic container is preferably heated by microwaves to dry said plastic container before flowing said dry gas inside said plastic container or at the same time said dry gas is flowed, or before blowing the inside of said plastic container with said heated dry gas or at the same time blowing with said heated dry gas is carried out. By simultaneously carrying out heating with microwaves when vacuum drying or drying with heated dry gas before the container is coated, the drying efficiency is improved.

Alternatively, in the methods of manufacturing a gas barrier film coated plastic container according to the present invention, said plastic container is preferably heated by a resistance wire type electric heater to dry said plastic container before flowing said dry gas inside said plastic container or at the same time said dry gas is flowed, or before blowing the inside of said plastic container with said heated dry gas or at the same time blowing with said heated dry gas is carried out. By simultaneously carrying out heating with a resistance wire type electric heater when vacuum drying or drying with heated dry gas before the container is coated, the drying efficiency is improved.

Further, a method of manufacturing a gas barrier film coated plastic container according to the present invention includes the steps of heating a plastic container by microwaves, and then blowing the inside of said plastic container with a dry gas to fill the inside of the container with the dry gas to dry said plastic container, or heating said plastic container by microwaves to dry said plastic container at the same time the inside of the plastic container is blown with dry gas to fill the inside of the container with the dry gas; and replacing the gas inside said plastic container with a source gas or a gas which includes a source gas, converting said source gas to plasma, and forming a gas barrier film on the inner surface of said plastic container by a CVD method. In the case where container heating by microwaves is carried out simultaneously, dry gas may be used in place of heated dry gas.

Alternatively, a method of manufacturing a gas barrier film coated plastic container according to the present invention includes the steps of heating a plastic container by a resistance wire type electric heater, and then blowing the inside of said plastic container with a dry gas to fill the inside of the container with the dry gas to dry said plastic container, or heating said plastic container by a resistance wire type electric heater to dry said plastic container at the same time the inside of the plastic container is blown with dry gas to fill the inside of the container with the dry gas; and replacing the gas inside said plastic container with a source gas or a gas which includes a source gas, converting said source gas to plasma, and forming a gas barrier film on the inner surface of said plastic container by a CVD method. In the case where container heating by a resistance wire type electric heater is carried out simultaneously, dry gas may be used in place of heated dry gas.

In the methods of manufacturing a gas barrier film coated plastic container according to the present invention, the period of time required from the time the replacement of the gas inside said plastic container with the source gas or the gas which includes the source gas is begun until the vacuum is opened after a gas barrier film is formed on the inner surface of said plastic container is preferably 10 seconds or less.

Further, in the methods of manufacturing a gas barrier film coated plastic container according to the present invention, said dry gas or said heated dry gas is preferably dehumidified air, carbon dioxide gas or nitrogen gas, and the dew point is preferably -20°C or lower.

In the methods of manufacturing a gas barrier film coated plastic container according to the present invention, a container formed from polyethylene terephthalate resin, polyethylene terephthalate type co-polyester resin, polybutylene terephthalate resin, polyethylene naphthalate resin, polystyrene resin, ethylene-vinyl alcohol copolymer resin, acrylonitrile resin, polyvinyl chloride resin, polyamide resin, polyamide-imide resin, polyacetal resin, polycarbonate resin, polysulfone resin, acrylonitrile-styrene resin, polyether sulfone resin or acrylonitrile-butadiene-styrene resin is preferably used as said plastic container.

### EFFECT OF THE INVENTION

The present invention prevents the gas barrier film formation from being hindered by water molecules absorbed in a plastic container, and makes it possible to provide a method of manufacturing a gas barrier film coated plastic container having a high gas barrier property. In particular, the present manufacturing methods are useful in the case where the CVD film forming process can not be carried out long in order to follow mass productivity. Further, the simultaneous use of heating by microwaves or a resistance wire type electric heater is useful in order to improve the container drying efficiency.

### BRIEF DESCRIPTION OF THE DRAWINGS

Fig. 1 is a cross-sectional schematic drawing showing a first embodiment of a dry gas filled plastic container preparing apparatus.
Fig. 2 is a cross-sectional schematic drawing showing a second embodiment of a dry gas filled plastic container preparing apparatus.
Fig. 3 is a cross-sectional schematic drawing showing a third embodiment of a dry gas filled plastic container preparing apparatus.
Fig. 4 is a conceptual drawing showing the basic structure of a rotary type CVD film forming apparatus.
Fig. 5 is a conceptual drawing showing the structure of one film forming chamber from the apparatus of Fig. 4.
Fig. 6 is a conceptual drawing of a rotary type apparatus in which film forming chambers are arranged on top of a turntable, and the film forming process is completed during the period of one rotation of the turntable.
Fig. 7 is a graph showing the change in pressure inside a vacuum chamber at the time a bottle is inserted in the vacuum chamber and vacuum formation is carried out.
Fig. 8 is a graph showing the change in elapsed time and bottle weight at the time the vacuum is opened after a bottle is inserted in the vacuum chamber and vacuum formation is carried out.

### DESCRIPTION OF THE SYMBOLS

1, 17 are plastic containers, 2 is a bell jar, 3 is a stage, 4, 22, 38 are O-rings, 5 is a dry gas supply pipe, 6 is a blowout hole, 7, 21 are exhaust pipes, 8 is a dry gas supply source, 9, 43 are mass flow meters, 10, 12, 15, 27, 42, 52 are vacuum valves, 11 is a vacuum gauge, 13, 25, 53 are vacuum pumps, 14, 26, 54 are exhaust ducts, 16 is a conveyor, 18, 23, 41, 44, 50 are pipelines, 24 is a pressure difference gauge, 28 is raising/lowering means, 29 is a heater, 30 is a lower portion external electrode, 31 is an upper portion external electrode, 32 is an external electrode, 33 is a conducting member 34 is an insulating member, 35 is a cover, 36 is a film forming chamber, 39 is an internal electrode, 40 is a gas blowout hole, 45 is a source gas generating means, 46 is source gas introduction means, 48 is an automatic matching device, 49 is a high frequency power source, 60 is heating means, and 61 is container support means.

### PREFERRED EMBODIMENTS OF THE INVENTION

The present invention is described in detail below with reference to preferred embodiments and specific examples, but it should not be interpreted that the present invention is limited to these descriptions.

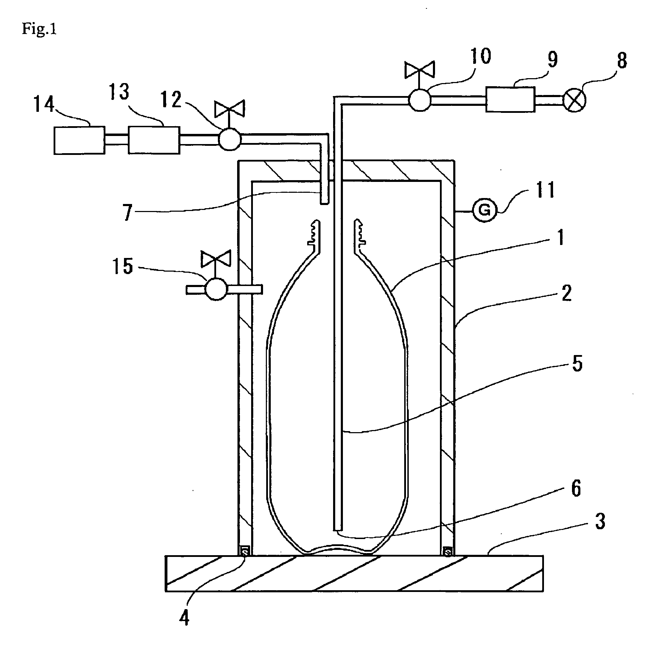

If the method of manufacturing a gas barrier film coated plastic container according to the present invention is largely divided, it is formed from (1) a plastic container drying process and (2) a CVD film forming process. A detailed description is given below with reference to an apparatus used in the manufacturing method according to the present embodiment in Fig. 1 ~ Fig. 6.

### First Embodiment - Preparing Process of Plastic Container Drying Process

Fig. 1 is a cross-sectional schematic drawing showing a first embodiment of a dry gas filled plastic container preparing apparatus. A cross section in the longitudinal direction of the container is shown. The present preparing apparatus houses a plastic container 1 inside a vacuum chamber formed from a bell jar 2 and a stage 3, and is formed so that a vacuum is formed and a dry gas can be introduced inside the vacuum chamber. The bell jar 2 and the stage 3 are sealed by the interposing of an O-ring 4 to form the vacuum chamber. After the plastic container 1 is placed on the stage 3, the stage 3 is raised or the bell jar 2 is lowered to house the plastic container 1 inside the vacuum chamber. At this time, a dry gas supply pipe 5 which can be freely inserted and removed through the mouth portion opening of the plastic container 1 is arranged inside the plastic container 1. A dry gas supplied from a dry gas supply source 8 undergoes flow control by a mass flow meter 9, and is guided to a vacuum valve 10 and the dry gas supply pipe 5. There is a blowout hole 6 in the tip of the dry gas supply pipe 5, and the dry gas is supplied to the inside of the plastic container 1 from the blowout hole 6. The dry gas supply pipe 5 is preferably arranged near the bottom of the plastic container 1. The dry gas supplied to the plastic container 1 is exhausted by an exhaust pipe 7. An exhaust hole of the exhaust pipe 7 is arranged above the mouth portion opening of the container, for example. The exhaust pipe 7 is connected to a vacuum pump 13 via a vacuum valve 12. Exhaust gas of the vacuum pump 13 is exhausted to an exhaust duct 14. Further, a vacuum gauge 11 for measuring the pressure inside the vacuum chamber is arranged in the bell jar 2. Further, a vacuum valve 15 is arranged in the bell jar 2.

The plastic container drying process (first embodiment) will be described using the dry gas filled plastic container preparing apparatus shown in Fig. 1.

The plastic container 1 is a container which has not yet undergone film formation, and is a container in which time has elapsed after being molded or a container immediately after molding, and it is possible to show examples of containers in which time has elapsed in a parison state or the like. After the plastic container 1 is placed on the stage 3, the stage 3 is raised. At this time, the dry gas supply pipe 5 is inserted in the mouth portion opening of the plastic container 1. Then, the bell jar 2 and the stage 3 are sealed by the O-ring 4 to form the vacuum chamber. The vacuum valve 15 and the vacuum valve 10 are closed. When the vacuum pump 13 is operated and the vacuum valve 12 is opened, the exhaustion of air inside the vacuum chamber is begun. Exhausting is carried out until the pressure inside the vacuum chamber reaches 100 Pa or lower.

In this regard, the attainment pressure is made to be 100 Pa or lower in order to accelerate the drying of the wall surfaces, namely, the inner surface of the container by lowering the pressure of the water content inside the vacuum chamber. The inner surface of the container is dried so that the formation of the gas barrier film is not hindered by water molecules.

By reducing the pressure inside the vacuum chamber, the entire plastic container 1, namely, the inside of the container and the outside of the container are placed under reduced pressure.

After the attainment pressure preferably becomes 100 Pa or lower, the reduced pressure is preferably maintained for a prescribed time of 15 - 300 seconds, for example. By arranging the plastic container 1 under reduced pressure for a prescribed time, the water absorbed inside the resin will volatilize from the inner surface and the outer surface of the plastic container. Further, the water molecules absorbed inside the resin will diffuse to the inner surface side and the outer surface side of the container and volatilize at the wall surfaces. In this way, the plastic container 1 is dried.

Next, after the vacuum valve 12 is closed and exhausting is stopped, the vacuum valve 10 is opened and the supplying of dry gas to the inside of the vacuum chamber is begun. The dry gas is blown out at the bottom inside the container from the blowout hole 6 of the tip portion of the dry gas supply pipe 5, and the inside of the container is filled with the dry gas. Excess dry gas overflows from the mouth portion of the plastic container and fills the inside of the vacuum chamber. This operation releases the vacuum of the vacuum chamber. Further, when the pressure shown on the vacuum gauge 11 becomes greater than or equal to the atmospheric pressure, the vacuum valve 15 is opened, and dry gas is exhausted to the outside of the vacuum chamber. By carrying out the above operation, a dry gas filled plastic container in which the inside of the container is filled with a dry gas is obtained.

The bell jar 2 is raised or the stage 3 is lowered, and after the bell jar 2 and the stage 3 are separated, the dry gas filled plastic container is removed from the vacuum chamber.

The removed dry gas filled plastic container in state with its mouth portion facing up is conveyed to a CVD film forming apparatus described later by container moving means such as a conveyor or the like. The conveying time is one hour or less, and more preferably 10 minutes or less.

At the same time the inner surface of the plastic container removed to the outside of the vacuum chamber is dried, because dry gas fills the inside of the container, outside air does not mix with the inside of the container. Accordingly, there is also no reabsorption of water from the outside air.

Dry gas filled plastic containers are sequentially prepared by this process.

The container according to the present invention includes a container that uses a cover or a stopper or is sealed, or a container used in an open state that does not use these. The size of the opening is determined in accordance with the contents. The plastic container includes a plastic container having a moderate stiffness and a prescribed thickness, and a plastic container formed from a sheet member that does not have stiffness. The substance that is filled into the plastic container according to the present invention can be a beverage such as a carbonated beverage or a fruit juice beverage or a soft drink or the like, as well as a medicine, an agricultural chemical, or a dried food which hates moisture absorption.

The manufacturing method of the present invention is particularly suited to the time a gas barrier film is formed in a plastic container having a high hygroscopicity. A high hygroscopic resin can be illustrated by polyethylene terephthalate resin, polyethylene terephthalate type co-polyester resin, polybutylene terephthalate resin, polyethylene naphthalate resin, polystyrene resin, ethylene-vinyl alcohol copolymer resin, acrylonitrile resin, polyvinyl chloride resin, polyamide resin, polyamide-imide resin, polyacetal resin, polycarbonate resin, polysulfone resin, acrylonitrile-styrene resin, polyether sulfone resin or acrylonitrile-butadiene-styrene resin. Of these, PET is particularly preferred. Further, olefin type resin absorbs a small amount of water, but the manufacturing method according to the present invention may of course be applied thereto.

In the present invention, the dry gas is dehumidified air, carbon dioxide gas or nitrogen gas, and in each case the dew point is preferably -20°C or lower. As shown in Table 1, the vapor pressure of ice at -20°C is 103.0 Pa. When the conditions in which the container volume is 1.5 liters and the relative humidity inside the container is 100% are established, if the dew point is -20°C or lower, the water content inside the container can be made 1.22 mg or less. Because carbon dioxide gas has a larger mass than air, it is preferred because it is difficult to escape to the outside when filled in a plastic container.

**TABLE 1 Calculation of the Vapor Pressure of Ice and Water and the Amount of Water inside Bottle at each temperature**

| Vapor Pressure of Ice and Water | | | Amount of Water inside Bottle | |
|---|---|---|---|---|
| Temperature °C | Pressure torr | Pressure Pa | Relative Humidity % | Amount of Water mg |
| -60 | 0.0081 | 1.08 | 100 | 0.01 |
| -50 | 0.0295 | 3.92 | 100 | 0.05 |
| -40 | 0.10 | 12.78 | 100 | 0.16 |
| -30 | 0.28 | 37.90 | 100 | 0.44 |
| -20 | 0.77 | 103.0 | 100 | 1.22 |
| -10 | 1.95 | 259.5 | 100 | 3.10 |
| -5 | 3.02 | 401.3 | 100 | 4.79 |
| 0 | 4.59 | 610.6 | 100 | 6.93 |
| 5 | 6.6 | 871.9 | 60 | 6.2 |
| 10 | 9.2 | 1,227.4 | 60 | 8.8 |
| 15 | 12.8 | 1,704.8 | 60 | 12.2 |
| 20 | 17.6 | 2,338.1 | 60 | 16.8 |
| 23 | 21.0 | 2,809.6 | 60 | 20.0 |
| 25 | 22.4 | 3,168.3 | 60 | 21.3 |
| 30 | 31.9 | 4,244.9 | | |
| 35 | 42.3 | 5,626.2 | | |
| 40 | 55.5 | 7,381.2 | | |
| 45 | 72.1 | 9,589.9 | | |
| 50 | 92.8 | 12,345 | | |
| 60 | 150.0 | 19,934 | | |
| 70 | 234.4 | 31,179 | | |
| 80 | 356.2 | 47,377 | | |
| 90 | 527.2 | 70,121 | | |
| 100 | 760.0 | 101,325 | | |

### Second Embodiment - Plastic Container Drying Process

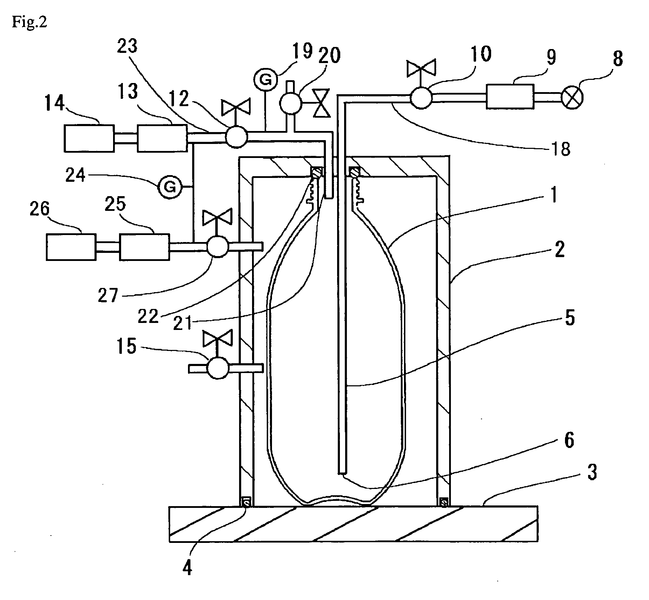

Next, a second embodiment of a plastic container drying process will be described with reference to Fig. 2.

Fig. 2 is a cross-sectional schematic drawing showing a second embodiment of a dry gas filled plastic container preparing apparatus. However, only the main portions of the apparatus are shown. A cross section in the longitudinal direction of the container is shown. The present preparing apparatus houses a plastic container 1 inside a vacuum chamber formed from a bell jar 2 and a stage 3. The bell jar 2 and the stage 3 are sealed by the interposing of an O-ring 4 to form the vacuum chamber. At this time, an O-ring 22 arranged inside the bell jar 2 makes contact with the mouth portion of the plastic container 1, and the mouth portion opening of the container is sealed. When the bell jar 2 seals the mouth portion opening of the plastic container 1, a dry gas supply pipe 5 and an exhaust pipe 21 are inserted and arranged inside the container. After the plastic container 1 is placed on the stage 3, the stage 3 is raised or the bell jar 2 is lowered to house the plastic container 1 inside the vacuum chamber. At this time, the dry gas supply pipe 5 which can be freely inserted and removed through the mouth portion opening of the plastic container 1 is arranged inside the plastic container 1. A dry gas supplied from a dry gas supply source 8 undergoes flow control by a mass flow meter 9 arranged in a pipeline 18, and is guided to a vacuum valve 10 and the dry gas supply pipe 5. There is a blowout hole 6 in the tip of the dry gas supply pipe 5, and the dry gas is supplied to the inside of the plastic container 1 from the blowout hole 6. The dry gas supply pipe 5 is preferably arranged near the bottom of the plastic container 1. The dry gas supplied to the plastic container 1 is exhausted by the exhaust pipe 21. An exhaust hole of the exhaust pipe 21 is preferably arranged near the mouth portion opening inside the container. The exhaust pipe 21 is connected to a vacuum pump 13 via a vacuum valve 12. Exhaust gas of the vacuum pump 13 is exhausted to an exhaust duct 14. Further, a vacuum gauge 19 for measuring the pressure inside the plastic container is arranged in a pipeline 23. Further, a vacuum valve 15 for vacuum chamber leaks is arranged in the bell jar 2, and a vacuum valve 20 for leaks inside the container is arranged in the pipeline 23. Further, in order to exhaust gas in the space between the inside of the vacuum chamber and the outside of the plastic container 1, exhaust means formed from a vacuum valve 27, a vacuum pump 25 and an exhaust duct 26 are arranged in the bell jar 2. Further, a pressure difference gauge 24 which detects the pressure difference between the pressure inside the container and the pressure inside the space between the inside of the vacuum chamber and the outside of the plastic container 1 is provided.

The method of preparing a dry gas filled plastic container (second embodiment) will be described using the dry gas filled plastic container preparing apparatus shown in Fig. 2.

The plastic container 1 is the same container which has not yet undergone film formation as that in the first embodiment. After the plastic container 1 is placed on the stage 3, the stage 3 is raised. At this time, the dry gas supply pipe 5 is inserted in the mouth portion opening of the plastic container 1. Then, the bell jar 2 and the stage 3 are sealed by the O-ring 4 to form the vacuum chamber. At the same time, the bell jar 2 and the mouth portion opening of the plastic container 1 are sealed by the O-ring 22. The vacuum valves 10, 15, 20 are closed. When the vacuum pump 13 is operated and the vacuum valve 12 is opened, the exhaustion of air inside the plastic container 1 is begun. Exhausting is carried out until the pressure inside the vacuum chamber reaches 100 Pa or lower. In this regard, the attainment pressure is made to be 100 Pa or lower for the reason described in the column of the first embodiment. At the same time a vacuum is created inside the plastic container 1, the vacuum pump 25 is operated and the vacuum valve 27 is opened to reduce pressure in the space between the inside of the vacuum chamber and the outside of the plastic container 1. At this time, pressure reduction is carried out at a level which does not cause crushing and deformation due to the creation of a vacuum inside the plastic container 1. Namely, the pressure difference between the inside pressure and the outside pressure of the plastic container is detected by the pressure difference gauge 24, and the pressure difference is controlled to be approximately 13300 Pa or lower in the case of PET bottles for carbonated soft drink, and 26600 Pa or lower in the case of PET bottles for heat resistance. Further, in the case where the plastic container has a wall thickness at a level in which crushing and deformation do not occur even when the pressure is reduced inside, or in the case where irregularities for preventing deformation are formed on the wall surfaces, it is possible to not carry out pressure reduction in the space between the inside of the vacuum chamber and the outside of the plastic container 1.

By this pressure reduction, at least the inside of the plastic container 1 is placed under reduced pressure.

After the attainment pressure preferably becomes 100 Pa or lower, the reduced pressure is preferably maintained for a prescribed time of 15 - 300 seconds, for example. By placing the inside of the plastic container 1 in a reduced pressure state for a prescribed time, the water content pressure inside the container is lowered, and the volatilization of water absorbed inside the resin from the inner surface of the plastic container will accelerate. Further, the water molecules absorbed inside the resin will diffuse to the inner surface side of the container and volatilize at the inner wall surface. In this way, the inner surface of the plastic container 1 and the inside of the resin near the inner surface are dried.

Next, after the vacuum valves 12, 27 are closed and exhausting is stopped, the vacuum valve 10 is opened and the supplying of dry gas to the inside of the vacuum chamber is begun. The dry gas is blown out at the bottom inside the container from the blowout hole 6 of the tip portion of the dry gas supply pipe 5, and the inside of the container is filled with the dry gas. This operation releases the vacuum of the vacuum chamber. Further, when the pressure shown on the vacuum gauge 19 becomes greater than or equal to the atmospheric pressure, the vacuum valve 20 is opened, and dry gas is exhausted to the outside of the apparatus. At the same time the supply of dry gas is begun and during the period of time dry gas is exhausted to the outside of the container, the vacuum valve 15 is opened and the space between the inside of the vacuum chamber and the outside of the plastic container 1 is released to atmospheric pressure. By carrying out the above operation, a dry gas filled plastic container in which the inside of the container is filled with a dry gas is obtained.

The bell jar 2 is raised or the stage 3 is lowered, and after the bell jar 2 and the stage 3 are separated, the dry gas filled plastic container is removed from the vacuum chamber.

The removed dry gas filled plastic container in state with its mouth portion facing up is conveyed to a CVD film forming apparatus described later by container moving means such as a conveyor or the like. The conveying time is one hour or less, and more preferably 10 minutes or less.

In the same way as in the case of the first embodiment, at the same time the inner surface of the plastic container is dried, there is no reabsorption of water from the outside air.

Dry gas filled plastic containers are sequentially prepared by this process.

### Third Embodiment - Plastic Container Drying Process

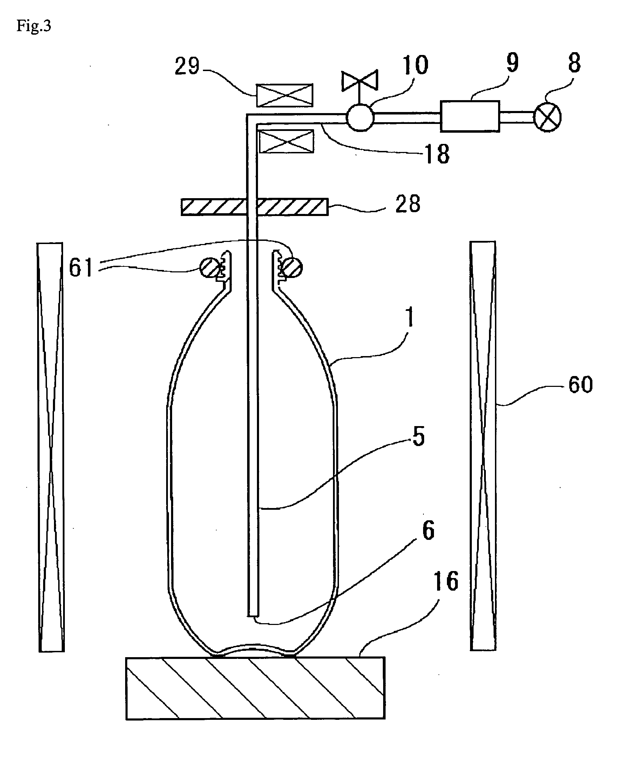

Next, a third embodiment of a plastic container drying process will be described with reference to Fig. 3.

Fig. 3 is a cross-sectional schematic drawing showing a third embodiment of a dry gas filled plastic container preparing apparatus. However, only the main portions of the apparatus are shown. A cross section in the longitudinal direction of the container is shown. The present preparing apparatus is equipped with a dry gas supply pipe 5, raising/lowering means 28 which raise and lower the dry gas supply pipe 5, and container support means 61 which clamps the mouth portion of the plastic container 1 to prevent lateral rolling of the container. The plastic containers 1 is placed on a conveyor 16 and conveyed one by one. By carrying out lowering with the raising/lowering means, the dry gas supply pipe 5 passes through the mouth portion opening of the plastic container 1 and is arranged inside the container. A dry gas supplied from a dry gas supply source 8 is guided to a mass flow meter 9 provided for flow control arranged in a pipeline 18, a vacuum valve 10, a heater 29 for heating the dry gas, and the dry gas supply pipe 5. There is a blowout hole 6 in the tip of the dry gas supply pipe 5, and the dry gas is supplied to the inside of the plastic container 1 from the blowout hole 6. The dry gas supply pipe 5 is preferably arranged near the bottom of the plastic container 1. The dry gas supplied to the plastic container 1 overflows from the mouth portion of the plastic container 1, and the inside of the container is blown by the dry gas.

The method of preparing a dry gas filled plastic container (third embodiment) will be described using the dry gas filled plastic container preparing apparatus shown in Fig. 3.

The plastic container 1 is the same container as that in the first embodiment. At the same time the plastic container 1 on the conveyor 16 is fixed by the container support means 61 to prevent lateral rolling, the raising/lowering means 28 is lowered at a timing which inserts the dry gas supply pipe 5 in the mouth portion opening of the container. When the raising/lowering means 28 is lowered, the dry gas supply pipe 5 passes through the mouth portion opening and is inserted inside the plastic container 1. At this time, the blowout hole 6 is arranged near the bottom of the container.

Next, the vacuum valve 10 is opened and the blowing of heated dry gas inside the plastic container 1 is begun. The heated dry gas is preferably 50 ~ 60°C. By using heated dry gas, drying can be completed rapidly. Further, if 60°C is exceeded, there is a lot of mixing of air carrying moisture due to volume contraction when the dry gas cools to normal temperature, and a risk of deformation of the plastic container occurs. On the other hand, if 50°C is not satisfied, drying is slow, and the process can not be carried out in a short time. Further, if the volume of the plastic container 1 is X ml, the blowing amount of dry gas is preferably 5•X ml or higher.

The heated dry gas is blown out at the bottom inside the container from the blowout hole 6 of the tip portion of the dry gas supply pipe 5, and the inside of the container is filled with the heated dry gas. By blowing with heated dry gas, the water content of the inner surface of the plastic container 1 volatilizes, and the water content absorbed inside the resin volatilizes. Further, the water molecules absorbed inside the resin will diffuse to the inner surface side of the container and volatilize at the inner wall surface. In this way, the inner surface of the plastic container and the inside of the resin near the inner surface are dried. The blowing time depends on the amount of blowing but is preferably 1 ~ 5 minutes.

The raising/lowering means 28 is raised, and the gas supply pipe 5 is removed from the inside of the container. The container support means 27 is opened, and the removed dry gas filled plastic container in state with its mouth portion facing up is conveyed to a CVD film forming apparatus described later by the conveyor 16. The conveying time is one hour or less, and more preferably 10 minutes or less.

In the same way as in the case of the first embodiment, at the same time the inner surface of the plastic container is dried, there is no reabsorption of water from the outside air.

In order to accelerate drying by the heated dry gas, the plastic container is preferably heated by a resistance wire type electric heater, or preferably a far infrared or infrared type heater outside the plastic container. In this case, for example, in a PET container, the temperature of the PET container can be raised to 60°C or lower in 30 seconds or less, for example, and this makes it possible to eliminate the problem where the time required for raising the temperature of the container becomes long due to the fact that the heat capacity of the heated dry gas is small. Preferably, microwaves which directly heat the plastic container itself and the water content are used, wherein 2450 MHz microwaves which are general use microwaves are particularly preferred, and the rapid drying of the container is efficient. In this case, for example, in a 20 g PET container, in the case where microwaves (2450 MHz) having an output of 600 ~ 1 kW are used, the time required to rapidly heat to 60°C can be made 10 seconds or less, and this makes it possible to shorten the drying rate considerably compared to the case where the drying of the container is carried out only by heated dry gas having a small heat capacity. The symbol 60 of Fig. 3 shows heating means such as a resistance wire type electric heater, a microwave generating source or the like. Further, when the container is simultaneously heated by a resistance wire type electric heater or microwaves, the gas flow rate of the heated dry gas is preferably made large in order to enlarge the humidity gradient, raise the evaporation factor and accelerate the drying rate. Incidentally, heated dry gas is the preferred gas to be used because it has a high saturation vapor pressure, but in the present embodiment dry gas may be used in the case where the container is simultaneously heated by a resistance wire type electric heater or microwaves.

Further, the heating of the container by a resistance wire type electric heater or microwaves may be carried out in the first embodiment or the second embodiment. In this way, the container drying efficiency can be improved.

Dry gas filled plastic containers are sequentially prepared by this process.

### CVD Film Forming Process

A CVD film forming process which forms a gas barrier film on the inner surface of a dry gas filled plastic container obtained by the preparing method of one of the 3 types of embodiments described above will now be described. The CVD film forming process is formed from (1) a replacing process which replaces the gas inside the plastic container with a source gas or a gas which includes a source gas, and (2) a gas barrier film forming process which converts the source gas to plasma and forms a gas barrier film on the inner surface of the plastic container by a CVD method.

In the present invention, either the supply of a high frequency or the supply of microwaves forming a high frequency in the broad sense is carried out in order to convert the source gas to plasma. In this regard, there is a capacitive coupling method and an inductive coupling method in high frequency discharging. As a representative example of these, an embodiment in which a high frequency is supplied to convert the source gas to plasma by a capacitive coupling method will be described.

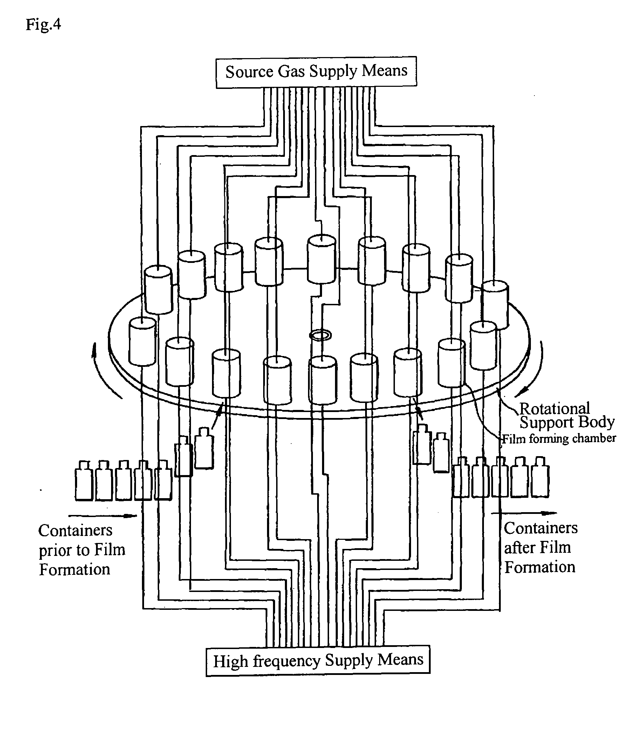

First, a CVD film forming apparatus which uses a high frequency will be described with reference to Fig. 4 - Fig. 6. Fig. 4 is a conceptual drawing showing the basic structure of a rotary type CVD film forming apparatus. This CVD film forming apparatus is a plasma CVD film forming apparatus equipped with film forming chambers which function as external electrodes, source gas introduction means which introduce a source gas that will be converted to plasma to the inside of each plastic container housed in the film forming chambers, and high frequency supply means which supply a high frequency to each external electrode of the film forming chambers, and is an apparatus wherein a high frequency is supplied to the external electrodes to convert the source gas to plasma inside the plastic containers, whereby a gas barrier film is formed on the inner surface of the plastic containers. This CVD film forming apparatus has a plurality of film forming chambers mounted on top of a turntable, and is a rotary type film forming apparatus which carries out film formation during the period of one rotation of the turntable.

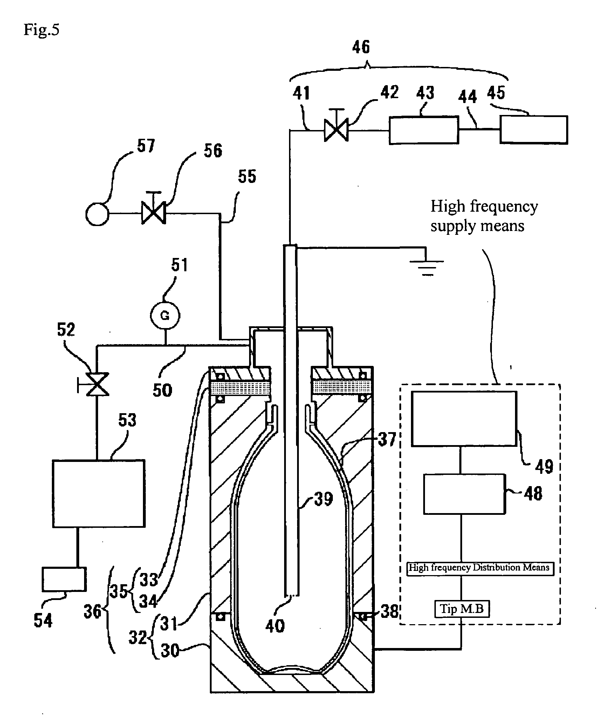

Fig. 5 is a conceptual drawing showing the structure of one film forming chamber from the apparatus of Fig. 4. As shown in Fig. 4, a film forming chamber 36 is constructed from an external electrode 32 which houses a plastic container 37, a grounded internal electrode 39 which is arranged to be freely inserted from the mouth portion to the inside of a plastic container, and a cover 35 to form a sealable vacuum chamber.

The cover 35 is formed from a conducting member 33 and an insulating member 34, and an insulated state is formed between the internal electrode 39 and the external electrode 32 when the internal electrode 39 is inserted inside the plastic container 37.

The insulating member 34 is arranged below the conducting member 33 to form the cover 35, and the external electrode 32 is arranged below the insulating member 34. The external electrode 32 is formed from an upper portion external electrode 31 and a lower portion external electrode 30, and is constructed so that the lower portion external electrode 30 is removably mounted to the lower portion of the upper portion external electrode 31 via an O-ring 38. The plastic container 37 can be loaded by removing and mounting the upper portion external electrode 31 and the lower portion external electrode 30.

A space is formed inside the external electrode 32, and this space is a housing space for housing a coating object plastic container, for example, the PET bottle 37 which is a container made from polyethylene terephthalate resin. In this regard, the housing space is preferably formed to be slightly larger than external shape of the PET bottle. Namely, the inner wall surface of the container housing space is preferably formed to have a shape that surrounds the vicinity of the outside of the plastic container. However, even though a similar shape is formed in this way in order to apply a bias voltage uniformly to the inner surface of the plastic container, there is no need to form a similar shape in the case where a bias voltage is applied uniformly by other means.

The internal electrode 39 is arranged inside the external electrode 32, and is arranged inside the plastic container 37. Namely, the internal electrode 39 is inserted from above the conducting member 33 through the space inside the conducting member 33 and the openings of the conducting member 33 and the insulating member 34 into the space inside the external electrode 32. The tip of the internal electrode 39 is arranged inside the PET bottle 37. The internal electrode 39 has a tubular shape which is hollow inside. A gas blowout hole 40 is provided in the tip of the internal electrode 39. Further, the internal electrode 39 is grounded.

In Fig. 5, the source gas introduction means 46 introduces a source gas supplied from a source gas generating source 45 to the inside of the plastic container 37. Namely, one side of a pipeline 41 is connected to the base end of the internal electrode 39, and the other side of the pipeline 41 is connected to one side of a mass flow controller 43 via a vacuum valve 42. The other side of the mass flow controller 43 is connected to the source gas generating source 45 via a pipeline 44.

The gas barrier film in the present invention can be illustrated by SiOx, DLC (which includes polymer-like carbon), aluminum oxide, and polymer like silicon nitride. Of these, DLC is particularly preferred because it has a superior oxygen barrier property and water vapor barrier property, is chemically inactive, can be disposed in the same way as plastic because carbon and hydrogen form the main components, and has the ability to follow the expansion and contraction of plastic because it is flexible. In the present invention, the DLC film is a film called an i-carbon film or an amorphous carbon hydride film (a-C:H), and also includes a hard carbon film. Further, a DLC film is an amorphous state carbon film, and includes SP³ bonding.

The source gas for forming this DLC film uses aliphatic hydrocarbons, aromatic hydrocarbons, oxygen-containing hydrocarbons, nitrogen-containing hydrocarbons or the like which form a gas or liquid at normal temperature. In particular, benzene, toluene, o-xylene, m-xylene, p-xylene, cyclohexane or the like having a carbon number of 6 or higher is preferred. In the case of being used in containers for food or the like, from the viewpoint of hygiene, aliphatic hydrocarbons, especially ethylene type hydrocarbons such as ethylene, propylene or butylene or the like, or acetylene type hydrocarbons such as acetylene, allylene or 1-butyne are preferred. These materials may be used separately or as a gas mixture of two or more types. Further, these gases may be used in a way in which they are diluted by a noble gas such as argon or helium. Further, a Si-containing hydrocarbon gas is used as a source gas for forming a Si-containing DLC film.

The space inside the conductive member 33 is connected to one side of a pipeline 50, and the other side of the pipeline 50 is connected to a vacuum pump 53 via a vacuum valve 52. The vacuum pump 53 is connected to an exhaust duct 54.

High frequency supply means are constructed by a fixed matching device (indicated as Tip M.B. in the drawings) provided in each external electrode, a high frequency power source 49, an automatic matching device 48 provided in the high frequency power source 49, and high frequency distribution means which uniformly supply the high frequency received from the automatic matching device to the fixed matching device.

A fixed matching device is provided in each external electrode, and impedance matching of the high frequency supplied by a coaxial cable and the plasma generated inside the external electrode is carried out. The fixed matching device is connected to the external electrode by a copper-plated wire of several Ω, for example.

The high frequency power source generates high frequency energy for converting source gas to plasma inside the plastic container. The frequency of the high frequency power source is 100 kHz - 1000 MHz, and the industrial frequency of 13.56 MHz is used, for example.

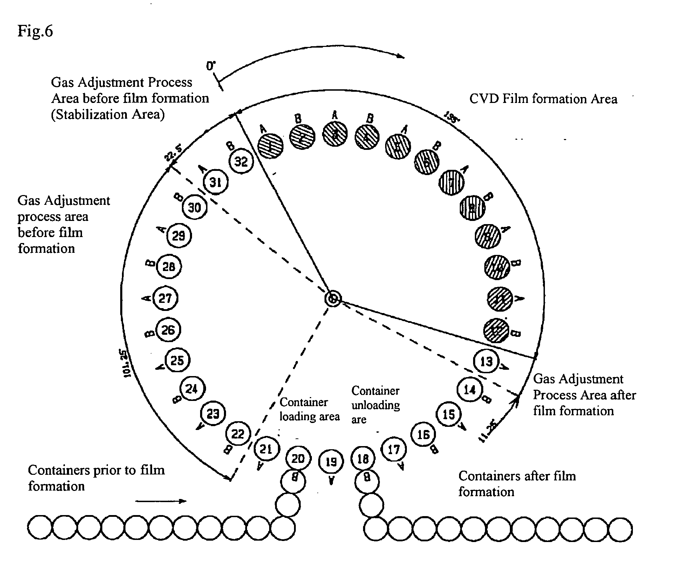

As shown in Fig. 6, film forming chambers are arranged on top of a turntable, and an apparatus may be formed in which the film forming process is carried out during the period of one rotation of the turntable.

Next, a method of forming a gas barrier film will be described using the CVD film forming apparatus shown in Fig. 4 ~ Fig. 6. The case of forming a DLC film as a gas barrier film is shown. The plastic container is made a PET bottle.

### Replacing Process

The vacuum valve 56 is opened to open the inside of the film forming chamber 36 to the atmosphere, and a state is formed in which the lower portion external electrode 30 is removed from the upper portion external electrode 31. Dry gas filled PET bottles (mentioned as containers prior to film formation in Fig. 4) supplied from a conveyor (not shown in the drawings) are removed by a container loading handling apparatus (not shown in the drawings), and the PET bottle 37 is provided by insertion from the bottom of the upper portion external electrode 31 of Fig. 5. At this time, the internal electrode 39 forms an inserted state inside the plastic container 37. Next, the lower portion external electrode 30 is mounted to the lower portion of the upper portion external electrode 31, and the external electrode 32 is sealed by the O-ring 38.

Next, after the vacuum valve 56 is closed, the vacuum valve 52 is opened, and the vacuum pump 53 is operated. In this way, the inside of the film forming chamber 36 including the inside of the PET bottle 37 are exhausted through the pipeline 50, whereby a vacuum is created inside the film forming chamber 36. At this time, the pressure inside the film forming chamber 36 is 2.6 ~ 66 Pa.

Next, the vacuum valve 42 is opened, a hydrocarbon gas (e.g., acetylene) is generated in the source gas generating source 45, the hydrocarbon gas is introduced inside the pipeline 44, and then the hydrocarbon gas which undergoes flow rate control by the mass flow controller 43 passes through the pipeline 41 and the internal electrode 39 and is blown out from the gas blowout hole 40. In this way, the hydrocarbon gas is introduced to the inside of the PET bottle 37. Then, by balancing the controlled gas flow rate and the air exhaust performance, the pressure inside the film forming chamber 36 and inside the PET bottle 37 is stabilized and maintained at a pressure (e.g., about 6.6 ~ 665 Pa) suitable for forming a DLC film.

### Gas Barrier Film Forming Process

In the film forming chamber 36, RF output (e.g., 13.56 MHz) is supplied by the high frequency supply means. In this way, plasma is generated between the external electrode 32 and the internal electrode 39. At this time, the automatic matching device 48 carries out impedance matching according to the inductance L and the capacitance C so as to minimize the reflected waves from the entire electrode supplying output. The fixed matching device converts the impedance of the coaxial cable to the impedance of plasma. In this way, hydrocarbon plasma is generated inside the PET bottle 37, and a DLC film is formed on the inner surface of the PET bottle 37. At this time, because there is no film formation hindrance due to water vapor, there is superior adhesion, and a fine DLC film is formed. The film formation time becomes about several seconds which is short. Next, the RF output from the high frequency supply means is stopped, and the plasma is extinguished to complete the formation of the DLC film. At about the same time, the vacuum valve 42 is closed and the supply of source gas is stopped.

Next, the vacuum valve 52 is opened, and the inside of the film forming chamber 36 and the inside of the PET bottle 37 is exhausted. Then, the vacuum valve 52 is closed and the exhaust is completed. Then, the vacuum valve 56 is opened. In this way, the inside of the film forming chamber 36 is opened to the atmosphere.

The PET bottle 37 is removed from the bottom of the upper portion external electrode 31 by a container removing handling apparatus (not shown in the drawings). Next, the coated containers (mentioned as containers after film formation in Fig. 4) are placed on a conveyor (not shown in the drawings) and conveyed away.

In the present embodiment, the time for one rotation of the turntable is preferably 12 seconds or less in order to carry out mass production. At this time, because the vacuum exhaust time in the replacement process must be 4 seconds or less, it is not possible to sufficiently remove water vapor. However, because a dry gas filled plastic container is prepared and a gas barrier film is formed therein, film formation hindrance due to water vapor volatilization does not occur. Accordingly, the gas barrier property can be improved when carrying out mass production.

In the present embodiment, a PET bottle for beverages was used as the container having a thin film formed on the inside, but it is also possible to use containers used for other uses.

Further, in the present embodiment, a DLC film or a Si-containing DLC film is the thin film formed by the CVD film forming apparatus, but it is also possible to use the film forming apparatus described above when forming other thin films inside containers.

The film thickness of the gas barrier film is formed to be 10 ~ 200 nm.

### SPECIFIC EXAMPLES

### Examination of Effect on Vacuum Formation Due to Amount of Moisture Absorption and Amount of Moisture Absorption of Plastic Container

A plastic container, for example, a PET bottle has an equilibrium water absorption coefficient of 0.4 - 0.5% by weight at 20°C and a relative humidity of 60 ~ 80%. When a 1.5 liter PET bottle has a weight of 50 g, 200 ~ 250 mg of water is absorbed. When a comparison (24 hours, 23°C) of water absorption coefficients is carried out, the amount of absorbed water of resins in which water absorption is difficult is 0.01% or less for polyethylene, 0.005% or less for polypropylene, and 0.04 - 0.06% or less for polystyrene. The amount of absorbed water of intermediate resins is 0.4 - 0.5% for PET, and 0.35% for polycarbonate. In resins having a high water absorption coefficient, it is 2.9% for polyimide, and 9.5% for nylon6. When a PET bottle is placed under reduced pressure by a vacuum pump, there is gas discharge (Water is understood to be the main component.) from the PET bottle, and this makes it difficult to reach a prescribed attainment pressure.

Using a 1.5 liter PET bottle, estimates of the vacuum formation time and the amount of water absorption when preparing a dry gas filled container are carried out. The purpose is (1) to observe the difference in the vacuum formation time between a bottle kept in a vacuum and a bottle kept in the atmosphere, and (2) to measure the weight change and estimate the amount of moisture reabsorption when a vacuum exhaust bottle is returned to the atmosphere.

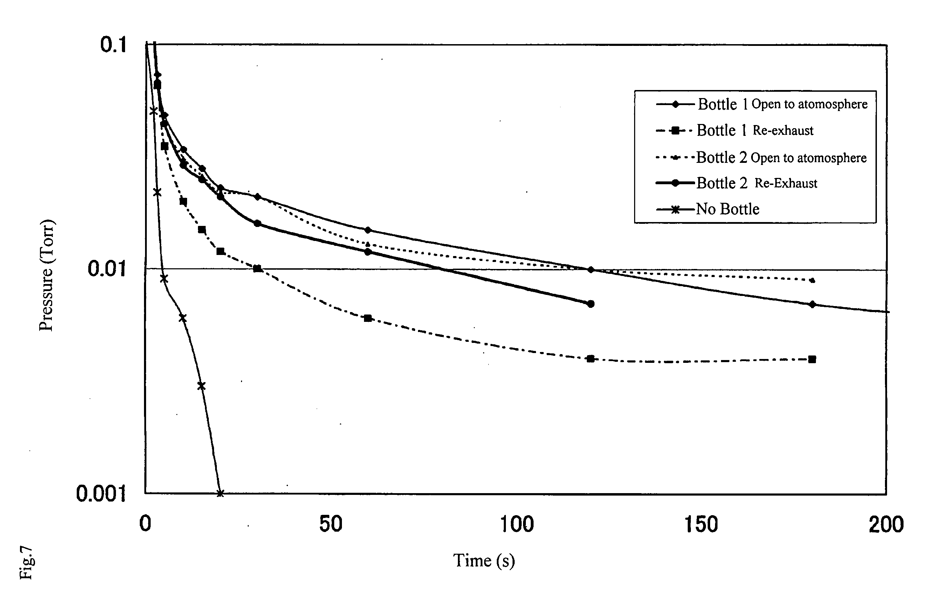

First, a vacuum is formed in the vacuum chamber of Fig. 5 when no bottle is inserted, and the change in pressure inside the vacuum chamber is examined. The experiment results are shown in Measurement Number 1 of Table 2. The results of Table 2 are graphed in Fig. 7. Next, a PET bottle (No. 1) left in the atmosphere is inserted in the same vacuum chamber, a vacuum is formed, and the change in pressure inside the vacuum chamber is examined. After vacuum exhaust is carried out for 300 seconds, the vacuum chamber is opened to the atmosphere temporarily, and the change in pressure inside the vacuum chamber is examined at the time re-exhaust is carried out immediately. The experiment results are shown in Measurement Number 2 of Table 2. Next, a PET bottle (No. 2) left in the atmosphere is inserted in the same vacuum chamber, a vacuum is formed, and the change in pressure inside the vacuum chamber is examined. After vacuum exhaust has been carried out for 180 seconds, the vacuum chamber is opened to the atmosphere temporarily, and the change in pressure inside the vacuum chamber is examined at the time re-exhaust is carried out after being left in the atmosphere for 4 minutes. The experiment results are shown in Measurement Number 3 of Table 2.

**TABLE 2**

| Measurement Number | 1 | 2 | 3 |
|---|---|---|---|
| Bottle Type | No Bottle | Bottle No.1 | Bottle No.2 |
| Exhaust Time (S) | Pressure (Pa) | | |
| 2 | 14. 23 | 17.16 | 16. 76 |
| 3 | 6. 65 | 9. 71 | 9. 18 |
| 5 | 2.93 | 6.38 | 5.85 |
| 10 | 1.20 | 4. 52 | 4. 12 |
| 15 | 0.80 | 3. 72 | 3. 46 |
| 20 | 0.40 | 3.06 | 2.93 |
| 30 | 0.13 | 2.79 | 2.79 |
| 60 | -0.40 | 2. 00 | 1. 73 |
| 120 | | 1. 33 | 1. 33 |
| 180 | | 0.93 | 1. 20 |
| 240 | | 0.80 | |
| 300 | | 0.80 | |
| | | Re-Exhaust carried out immediately after opening to the atomosphere | Re-Exhaust carried out after 4 minutes of being left open to the atomosphere |

| Re-Exhaust Time (S) | Pressure (Pa) | | |
|---|---|---|---|
| 2 | | 15. 96 | 16. 36 |
| 3 | | 8. 65 | 8. 91 |
| 5 | | 4. 66 | 5.85 |
| 10 | | 2. 66 | 3. 86 |
| 15 | | 2. 00 | 3. 33 |
| 20 | | 1. 60 | 2. 79 |
| 30 | | 1. 33 | 2. 13 |
| 60 | | 0. 80 | 1. 60 |
| 120 | | 0. 53 | 0. 93 |
| 180 | | 0. 53 | |

In Table 2 and Fig. 7, the relationship between the exhaust time and the pressure in the state where there is no bottle (Measurement Number 1 of Table 2) forms a base. Next, at the time a vacuum was formed in the bottle 1 left in the atmosphere (first part of Measurement Number 2 of Table 2), the rate of vacuum formation was slow, and volatilization of water from the bottle 1 is assumed. Further, at the time re-exhaust is carried out immediately after the bottle 1 is temporarily being returned to the atmosphere (later part of Measurement Number 2 of Table 2), the exhaust is fast. Because water has already volatilized from the container, a vacuum formation delay due to water volatilization is believed to be inconspicuous. Next, at the time a vacuum was formed in the bottle 2 left in the atmosphere (first part of Measurement Number 3 of Table 2), the results were roughly the same as those of the case of the bottle 1 (first part of Measurement Number 2 of Table 2). Further, in the container in which re-exhaust is carried out after being left open to the atmosphere for 4 minutes (later part of Measurement Number 3 of Table 2), the film formation rate was roughly the same level as the bottle left in the atmosphere (first part of Measurement Number 2 of Table 2, first part of Measurement Number 3 of Table 2). In this way, it is believed that gas molecules are removed from the surface by maintaining a vacuum, re-adsorption occurs when it is returned to the atmosphere, and a state close to saturation is reached in approximately 4 minutes.

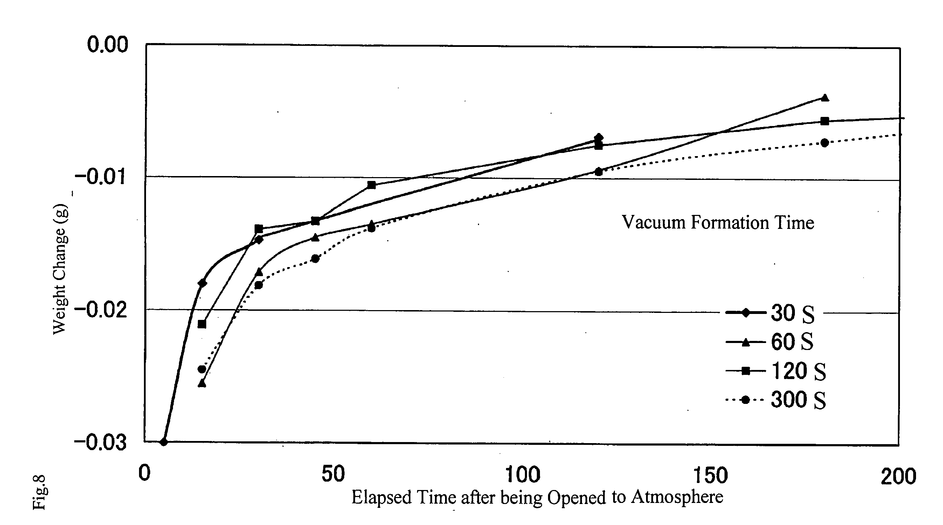

Next, a PET bottle was inserted in the vacuum chamber of Fig. 5, and after vacuum formation was carried out for 30 seconds, the change in the bottle weight after the elapse of a period of time from the time it was opened to the atmosphere is shown in Table 3. In the same way, after vacuum formation was carried out for 60 seconds, 120 seconds and 300 seconds, the changes in the bottle weight after the elapse of a period of time from the time it was opened to the atmosphere are shown in Table 3. The results of Table 3 are graphed in Fig. 8.

**TABLE 3**

| Vacuum Formation Time (S) | 3 0 | 6 0 | 1 2 0 | 3 0 0 |
|---|---|---|---|---|
| Bottle Weight before Exhaust (g) | 52.7640 | 52.7315 | 52.6885 | 52.6838 |

| Elapsed Time after opening to atomosphere (S) | Bottle Weight (g) | | | |
|---|---|---|---|---|
| 5 | 52.7340 | | | |
| 15 | 52.7460 | 52.7060 | 52.6674 | 52.6593 |
| 30 | 52.7493 | 52.7144 | 52.6746 | 52.6657 |
| 45 | | 52.7170 | 52.6752 | 52.6677 |
| 60 | | 52.7180 | 52.6779 | 52.6700 |
| 120 | 52.7571 | 52.7221 | 52.6810 | 52.6743 |
| 180 | | 52.7277 | 52.6829 | 52.6766 |
| 240 | | | 52.6837 | 52.6782 |
| 300 | | | 52.6838 | 52.6784 |
| Weight Difference at the time 15 s has elapsed (g) | 0.0180 | 0.0255 | 0.0211 | 0.0245 |

In Table 3 and Fig. 8, a weight change of the vacuum exhaust bottle appears even for the vacuum formation time of 30 seconds which is a relatively short exhaust time, and the weight reduction is about 30 mg after 5 seconds of exposure to the atmosphere, 18 mg after 15 seconds, 15 mg after 30 seconds, and 7 mg after 120 seconds, whereby the weight is restored rapidly when returned to the atmosphere. This is believed to be mainly due to gas adhering to the PET surface. The adhered gas is believed to be mainly water. In the actual process of the film forming process, because a 30-second vacuum formation time can not be prepared, it is beneficial to prepare a dry gas filled plastic container in advance before it is passed to a film forming apparatus. From Table 4, if the vacuum formation time is 30 ~ 300 seconds, the weight difference (after the elapsed time of 15 seconds) becomes about 18~25 mg, whereby it is understood that it is effective in removing water from the container.

### Examination of Vacuum Formation Time and Gas Barrier Property of Bottle Kept at Normal Temperature

Next, an examination was carried out on the gas barrier property at the time a DLC film was formed in a PET bottle (1.5 liter) kept at room temperature in that state using the apparatus of Fig. 5. The vacuum formation time (seconds) is the pressure reduction time for replacing the gas inside the plastic container inside the vacuum chamber with acetylene source gas. After this pressure reduction, the source gas is supplied to the inside of the plastic container, and film formation is carried out from a film formation pressure of 13.3 Pa, for example. An 800 W high frequency (13.56 MHz) is supplied to the external electrode of Fig. 5. The film formation time was 2.5 seconds, and the film thickness was 25 nm. As for the oxygen barrier property, measurements of the amount of oxygen permeation (cc/day/pkg) were carried out using an OX-TRAN2/21 (mention as OTR below) manufactured by Mocon Company, with the inside of the container at 23°C - 55%RH, the outside of the container at 23°C - 100%RH, and the oxygen partial pressure at 21 %. The term pkg is the abbreviation for package. The results are shown in Table 4.

**TABLE 4**

| Vacuum Formation Time (s) | 4 * (Note 1) | 4 | 8 | 15 | 30 | 60 |
|---|---|---|---|---|---|---|
| OTR cc/day/pkg | 0.0159 | 0.0133 | 0.0147 | 0.0107 | 0.0077 | 0.0065 |

| | | | | | | |
|---|---|---|---|---|---|---|
| 4* Note 1: The container is opened to the atmosphere after 30 seconds of vacuum exhaust, and then re-exhaust is carried out. The vacuum formation time at the time of re-exhaust is 4 seconds. | | | | | | |

As is understood from Table 4, when the vacuum formation time is made long, it is understood that the oxygen barrier property improves because the plastic container is also dried. However, the vacuum formation time at the time of source gas replacement needs to be at least 60 seconds or higher to carry out drying in the CVD film forming process, and this makes it impossible to complete the CVD film forming process in a short time (e.g., 12 seconds or less).

### Examination of PE Bottle

A PE bottle and a PET bottle were compared. The bottles were inserted in the vacuum chamber of Fig. 5, and the times (attainment times) required to reach the attainment pressure of 2.93 Pa and weight reductions of the bottles immediately after being opened to the atmosphere were compared. The results are shown in Table 5. Because it is more difficult for PE to absorb moisture than PET, the attainment time is short, and the weight reduction is small.

**TABLE 5**

| | Attainment Pressure P a | Attainment Time (Second) | Amount of Weight Reduction mg | Reference |
|---|---|---|---|---|
| Empty Bottle | 2. 93 | 5 | ― | |
| PE Bottle | 2. 93 | 6 | 2 | |
| PET Bottle | 2. 93 | 2 0 ~ 3 0 | 2 2 | n=4 |

Here, the weight reduction is (weight before exhaust) - (weight 15 seconds after being opened to the atmosphere).

### Examination of Film Formation Weight, Amount of Moisture Absorption of Resin of Inner and Outer Surface Portions, and Amount of Water Inside Container

From the examination described above, it was understood that vacuum formation is delayed and the oxygen gas barrier property is lowered by water inside the bottle, and the weight ratio between the amount of volatilization of water and the gas barrier film, for example, a DLC film is compared.

### (1) Film Formation Weight

The surface area of a 1.5 liter (maximum outside diameter 95 × 305 mmH) PET bottle is made 800 cm². The film formation thickness is made 25 nm. The density of the film is made 1.4 g/cm³. The weight of the film becomes 800 cm² × 25 nm × 1.4=2.8mg.

### (2) Amount of Water Inside Container

The composition of air inside a 1.5 liter PET bottle is calculated. The temperature is made 23°C, and the relative humidity is made 60%. The vapor pressure of water at 23°C is 21 mmHg × 0.6 = 12.6 mmHg. The weight of water vapor at 23°C (without temperature correction) is 18000 mg / 22.4 L × 1.5 L × 12.6 mmHg / 760 mmHg = 20 mg. The weight of the air components other than water vapor is 29000 mg / 22.4 L × 1.5 L × (760 - 12.6) mmHg / 760 mmHg = 1.909 g.

### (3) Amount of Moisture Absorption of Resin of Inner and Outer Surface Portions of Container

The amount of absorbed water of the container itself is 200 ~ 250 mg, but the amount of water of the inner and outer surface portions of the bottle (vacuum maintenance ⇒ container weight difference at the time of 15 seconds from being opened to atmosphere) was 22 mg.

(4) (Amount of moisture absorption of resin at inner and outer surface portions of the container + amount of water inside container) is 22 mg + 20 mg = 42 mg.

(5) Accordingly, when a 2.8 mg gas barrier film is formed, 22 mg (maximum 200 - 250 mg) of water volatilizes from the film formation surfaces at the same time, and 11 mg (maximum 100 ~ 125 mg) of water volatilizes when limited to the inner surface. In this way, the volatilization of water is assumed to hinder film formation.

### Specific Example at the Time the Plastic Container Drying Process is Provided

Next, a specific example is shown at the time a plastic container drying process is provided, and then a CVD film forming process is carried out using the apparatus of Fig. 5. The plastic container drying process carries out either a vacuum - dry gas filling process (A-1) according to Embodiment 1 using the apparatus of Fig. 1, or a dry gas blowing process (A-2) which blows the inside of the container with a heated dry gas according to Embodiment 3 using the apparatus of Fig. 3. The conditions were the same for the CVD film forming process. The case where a DLC film is formed as a gas barrier film is shown. The source gas was acetylene, the plastic container was a 1.5 liter PET bottle, the high frequency output was 800 W, the film formation time was 2 seconds, and the film thickness of the DLC film was 20 nm. The oxygen gas barrier property was measured using the same method described above. The measurement conditions and the results thereof are shown in Table 6.

**TABLE 6**

| | **A-1** Vacuum-Dry Gas filling Process | | | **A-2** Dry Gas Blowing Process | | **B** CVD film forming process | | | | Oxygen permeability |
|---|---|---|---|---|---|---|---|---|---|---|
| | Vacuu m Forma tion (Pa) | Mainte nance Time (s) | Type of Dry Gas | Gas Type, Temperature | Blow Rate (l/min) Blow Time (s) | Holding until film formati on line (m) | Vacu um (Pa) | Vacuum time (s) | Film forming(s) | cc/day/pkg |
| Specific 1 | 100 | 15 | dehumidified nitrogen gas | not carried out | | 10 | 6.7 | 4 | 2 | 0.0065 |
| Sepcific 2 | 100 | 30 | ehumidified nitrogen gas | not carried out | | 10 | 6.7 | 4 | 2 | 0.0054 |
| Specific 3 | 100 | 60 | dehumidified nitrogen gas | not carried out | | 10 | 6.7 | 4 | 2 | 0.0050 |
| Specific 4 | 100 | 300 | dehumidified nitrogen gas | not carried out | | 10 | 6.7 | 4 | 2 | 0.0045 |
| Specific 5 | 100 | 30 | dehumidified nitrogen gas | not carried out | | 60 | 6.7 | 4 | 2 | 0.0068 |
| Secific 6 | 100 | 30 | dehumidified nitrogen gas | not carried out | | 10 | 6.7 | 4 | 2 | 0.0054 |
| Specific Example 7 | **not carried out** | | | Normal temperature dehumidified nitrogen gas. | Blow amount 20 Blow Time 30 (s) | 60 | 6.7 | 4 | 2 | 0.0090 |
| Reference Example 1 | 100 | 300 | dehumidifed nitrogen gas | not carried out | | 1800 | 6.7 | 4 | 2 | 0.0151 |
| Comparative Example 1 | **not carried out** | | | not carried out | | - | - | - | 2 | 0.0752 |
| Comparative Example 2 | **not carried out** | | | not carried out | | 10 | 6.7 | 4 | 2 | 0.0152 |
| Comparative Example 3 | 100 | 30 | Normal Air | not carried out | | 10 | 6.7 | 4 | 2 | 0.0141 |
| Comparative Example 4 | **not carried out** | | | Normal temperature dehumidinfied nitrogen Gas | Blow amount 20 Blowe Time 600(s) | 10 | 6.7 | 4 | 2 | 0.0132 |

Specific Examples 1 - 5 are cases where a vacuum - dry gas filling process was carried out according to Embodiment 1. Vacuum formation was carried out to 100 Pa, and the vacuum maintenance time thereof was changed. When any one of these is compared to Comparative Example 2 in which the processes A-1 and A-2 are not carried out, the oxygen barrier property is high. Further, the oxygen barrier property of an uncoated plastic container is shown as Comparative Example 1. When Specific Examples 1 - 5 and Specific Example 6 are compared, it is understood that dehumidified nitrogen gas and dehumidified air are effective. Further, dry carbon dioxide gas has the same effect. Next, the case where the dry gas blowing process according to Embodiment 3 is carried out is shown as Specific Example 7. Comparative Example 4 is the case where room temperature dry gas is blown instead of heated dry gas, and the effect on the oxygen barrier property is weak even when blowing is carried out for a long time. The drying rate is believed to be improved by using heated dry gas. Further, in the case of Comparative Example 3 in which the container is filled with normal air, the oxygen gas barrier property is lower compared to the specific examples because water in the air is re-adsorbed. Further, the case in which there is a long retention time (1800 minutes) until film formation by a CVD film forming apparatus after the inside of the container is filled with dry gas as a reference example was shown. Because the diffusion of air to the inside of the container from the container mouth portion occurs, this case is the same as Comparative Example 2. The time until film formation is preferably short.

## Claims

1. A method of manufacturing a gas barrier film coated plastic container, comprising the steps of:
reducing the pressure inside a plastic container or reducing the pressure of the entire plastic container;
flowing a dry gas as a leak gas at the time the vacuum is opened to fill the inside of the container with said dry gas to dry said plastic container; and
replacing the gas inside said plastic container with a source gas or a gas which includes a source gas, converting said source gas to plasma, and forming a gas barrier film on the inner surface of said plastic container by a CVD (Chemical Vapor Deposition) method.

2. The method of manufacturing a gas barrier film coated plastic container described in Claim 1, wherein the reduced pressure inside said plastic container or the reduced pressure of the entire plastic container forms an attainment pressure of 100 Pa or lower.

3. A method of manufacturing a gas barrier film coated plastic container, comprising the steps of:
blowing the inside of a plastic container with a heated dry gas at 50 ~ 60°C to fill the inside of the container with said heated dry gas to dry said plastic container; and
replacing the gas inside said plastic container with a source gas or a gas which includes a source gas, converting said source gas to plasma, and forming a gas barrier film on the inner surface of said plastic container by a CVD method.

4. The method of manufacturing a gas barrier film coated plastic container described in Claim 1, 2 or 3, wherein said plastic container is heated by microwaves to dry said plastic container before flowing said dry gas inside said plastic container or at the same time said dry gas is flowed, or before blowing the inside of said plastic container with said heated dry gas or at the same time blowing with said heated dry gas is carried out.

5. The method of manufacturing a gas barrier film coated plastic container described in Claim 1, 2 or 3, wherein said plastic container is heated by a resistance wire type electric heater to dry said plastic container before flowing said dry gas inside said plastic container or at the same time said dry gas is flowed, or before blowing the inside of said plastic container with said heated dry gas or at the same time blowing with said heated dry gas is carried out.

6. A method of manufacturing a gas barrier film coated plastic container, comprising the steps of:
heating a plastic container by microwaves, and then blowing the inside of said plastic container with a dry gas to fill the inside of the container with the dry gas to dry said plastic container, or heating said plastic container by microwaves to dry said plastic container at the same time the inside of the plastic container is blown with dry gas to fill the inside of the container with the dry gas; and
replacing the gas inside said plastic container with a source gas or a gas which includes a source gas, converting said source gas to plasma, and forming a gas barrier film on the inner surface of said plastic container by a CVD method.

7. A method of manufacturing a gas barrier film coated plastic container, comprising the steps of:
heating a plastic container by a resistance wire type electric heater, and then blowing the inside of said plastic container with a dry gas to fill the inside of the container with the dry gas to dry said plastic container, or heating said plastic container by a resistance wire type electric heater to dry said plastic container at the same time the inside of the plastic container is blown with dry gas to fill the inside of the container with the dry gas; and
replacing the gas inside said plastic container with a source gas or a gas which includes a source gas, converting said source gas to plasma, and forming a gas barrier film on the inner surface of said plastic container by a CVD method.

8. The method of manufacturing a gas barrier film coated plastic container described in Claim 1, 2, 3, 4, 5, 6 or 7, wherein the period of time required from the time the replacement of the gas inside said plastic container with the source gas or the gas which includes the source gas is begun until the vacuum is opened after a gas barrier film is formed on the inner surface of said plastic container is 10 seconds or less.

9. The method of manufacturing a gas barrier film coated plastic container described in Claim 1, 2, 3, 4, 5, 6, 7 or 8, wherein said dry gas or said heated dry gas is dehumidified air, carbon dioxide gas or nitrogen gas, and the dew point is - 20°C or lower.

10. The method of manufacturing a gas barrier film coated plastic container described in Claim 1, 2, 3, 4, 5, 6, 7, 8 or 9, wherein a container formed from polyethylene terephthalate resin, polyethylene terephthalate type co-polyester resin, polybutylene terephthalate resin, polyethylene naphthalate resin, polystyrene resin, ethylene-vinyl alcohol copolymer resin, acrylonitrile resin, polyvinyl chloride resin, polyamide resin, polyamide-imide resin, polyacetal resin, polycarbonate resin, polysulfone resin, acrylonitrile-styrene resin, polyether sulfone resin or acrylonitrile-butadiene-styrene resin is used as said plastic container.
